# EUROPEAN PATENT APPLICATION

(11) **EP 1 936 696 A1**
(43) Date of publication of application: **25.06.2008**
(21) Application number: 06127148.2
(22) Date of filing: 22.12.2006
(51) Int. Cl.: H01L 29/778, H01L 29/78, H01L 21/336, H01L 21/338

(54) **A field effect transistor device and methods of production thereof**

(71) Applicant: INTERUNIVERSITAIR MICROELEKTRONICA CENTRUM vzw (IMEC), 3001 Leuven (BE)
(72) Inventor: Heyns, Marc, 3210, LINDEN (BE); Meuris, Marc, 3140, KEERBERGEN (BE)
(74) Representative: Van Malderen, Joëlle

(57) **Abstract**

The present invention is related to a semiconductor transistor device comprising a channel area (1), said channel area comprising :
- a channel layer in which charge carriers can move when the transistor is turned on, in order to pass a current through the transistor,
- a source area (4) and a drain area (5),

wherein said channel layer consists of a III-V material, and said source and drain areas comprise SiₓGe₁₋ₓ, with x between 0 and 100%, arranged so that heterojunctions (30,31) are present between III-V material and SiₓGe₁₋ₓ, said heterojunctions being arranged so said current passes through said heterojunctions (30,31).

## Description

### Field of the Invention

The present invention is related to a method for producing a semiconductor transistor device, e.g. a metal-oxide semiconductor field-effect transistor (MOSFET) or High Electron Mobility Transistor (HEMT), using semiconductor materials such as III-V materials (e.g. GaAs), preferably III-V materials with a high bandgap (>1eV), and Ge, in order to create a device with improved capabilities.

### State of the Art

The use of Ge, SiₓGe₁₋ₓ and of III-V materials such as GaAs, is known in the production of semiconductor devices. These materials have superior characteristics in terms of the mobility of charge carriers (electrons or holes), which makes them highly suitable for the production of improved FET devices.

However, a number of problems have been acknowledged, in particular in relation to the use of III-V materials in CMOS technology. Ion implantation of GaAs for example is not an easy operation, due to the difficulty of annealing out the defects, after the ion bombardment of a GaAs area. Another problem is the contacting of III-V materials. On GaAs and other similar materials, it is difficult to obtain low resistive contacts, and complex metallization schemes have to be used.

### Aims of the Invention

The present invention aims to provide a semiconductor transistor device, such as a MOSFET or HEMT which provides a solution for the problems identified above.

### Summary of the Invention

The invention is related to a method and devices such as described in the appended claims. The invention is related to a semiconductor transistor device, provided with a source and drain area produced in or on a semiconductor substrate, more particularly in or on a so-called 'active area' of a substrate, which is delimited by field areas (field oxides/dielectric areas). In between the source and drain area's, a channel area is provided. A gate electrode and contact is provided above the channel to modulate the conductivity of the channel, while source and drain contacts are provided to contact the channel. In a device of the invention, which can be a MOSFET, a HEMT or other devices having the abovementioned parts, the material provided in the channel layer, i.e. in the layer in which movement of the charge carriers is to take place, is a III-V material, e.g. GaAs, while the source and drain area's comprise SiₓGe₁₋ₓ, with x between 0 and 100%, and arranged so that heterojunctions are present between III-V material and SiₓGe₁₋ₓ, said heterojunctions being arranged so that current passing through the transistor device under control of the gate electrode from source to drain, passes through said heterojunctions. According to one embodiment, x is smaller than 100%. According to other embodiments, x is - respectively - smaller than 90%, 80% and 70%.

### Brief Description of the Drawings

Fig. 1 represents a device according to a first embodiment of the invention.

Fig. 2 represents a device according to a second embodiment of the invention.

Fig. 3 represents a device according to a third embodiment of the invention.

Fig. 4 represents a graph showing III-V materials which are included in the preferred scope of the invention. Figure 4 is taken from prior art literature.

Fig. 5 illustrates a device of the invention wherein source and drain areas are subjected to a germanidation.

Fig. 6 represents a specific example of a device according to the first embodiment.

Fig. 7 represents an example of a HEMT device according to the invention.

### Detailed Description of the Invention

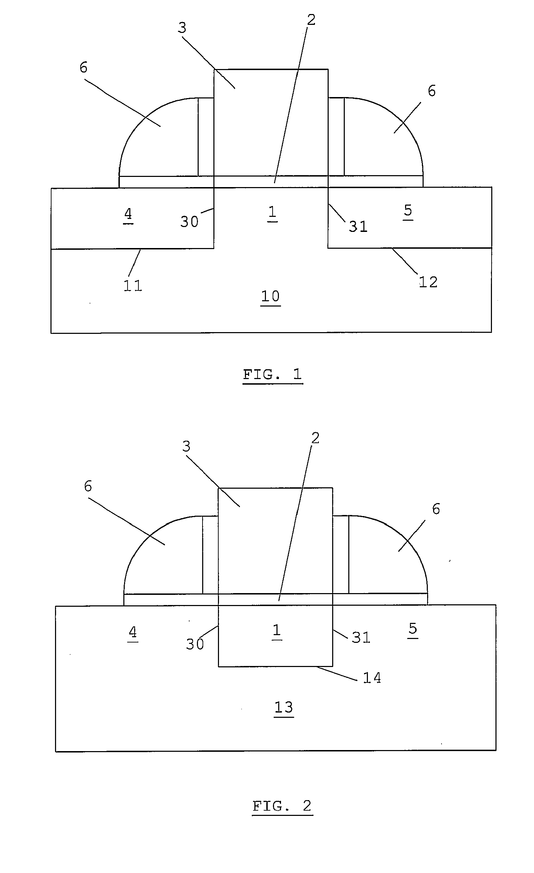

The invention is related to a semiconductor transistor device, for example a MOSFET, such as shown in figures 1 and 2. The figures show only the active area on which one device is built. It is to be understood that field areas surround the device shown in each drawing. A MOSFET according to the invention comprises the classic components, namely a first semiconductor area called the channel 1, located underneath the gate dielectric 2 and gate electrode 3. The channel lies in between two semiconductor areas 4 and 5, called source and drain areas respectively. Spacers 6 are normally present on either side of the gate 3. In the case of a MOSFET, as shown in the drawings, the actual channel is the interface between the top layer (called 'channel layer' in the context of this patent application) in the channel area 1 and the dielectric 2. According to the invention, at least the channel layer of the channel area consists of a III-V material, for example GaAs, while the source and drain areas comprise SiGe, so that a heterojunction (30,31) is formed in each of the border areas between III-V material and SiGe, said heterojunction being arranged so that the current flowing in the channel passes through said heterojunction.
In a HEMT device, the structure is similar to the one shown in figures 1 and 2, but the channel area 1 is built from several layers, designed to obtain a 2-dimensional electron gas in a conducting layer sandwiched between two active layers. The dielectric layer 2 is not necessarily present in a HEMT device. In a HEMT according to the invention, at least one of said active layers (the channel layer) consists of a III-V material, while the source and drain areas comprise SiGe, so that again, a heterojunction is formed in each of the border areas between III-V material and SiGe, said heterojunction being arranged so that the current flowing through the channel passes through said heterojunction. Any device according to the invention is characterized by the presence of a heterojunction between SiGe and III-V material, said heterojunction being arranged so that the current flowing through the channel passes through said heterojunction.

The term 'SiGe' (silicon-germanium) is to be understood in the context of this application as SiₓGe₁₋ₓ, with x between 0 and 100%, so it is a range of materials with differing concentrations of Si and Ge, the included limits being pure Si and pure Ge. This is the way 'SiGe' is generally interpreted by a person skilled in the art of semiconductor technology. Where appropriate, the full expression 'SiₓGe₁₋ₓ' is used, otherwise simply 'SiGe'. Preferred embodiments exclude the use of pure Si in various ranges (respectively, x<100%, <90%, <80% and <70%).

According to a first embodiment, shown in fig. 1, the device of the invention comprises a substrate 10 of III-V material, wherein openings 11, 12 have been produced, e.g, by etching, and wherein said openings have been filled with SiGe, to form the source and drain areas 4,5.

According to a second embodiment, shown in figure 2, the device comprises a substrate 13 of SiGe, wherein an opening 14 has been produced, e.g. by etching, and wherein said opening has been filled with a III-V material, e.g. GaAs, to form the channel area 1. In both cases, the final result is a MOSFET, comprising a III-V channel 1 and SiGe source and drain areas 4 and 5. In both embodiments, the difficulty of doping the source and drain areas is no longer present, because SiGe can be easily doped by ion-implantation or in-situ doping techniques. Furthermore, SiGe can be easily contacted through various metallization schemes.

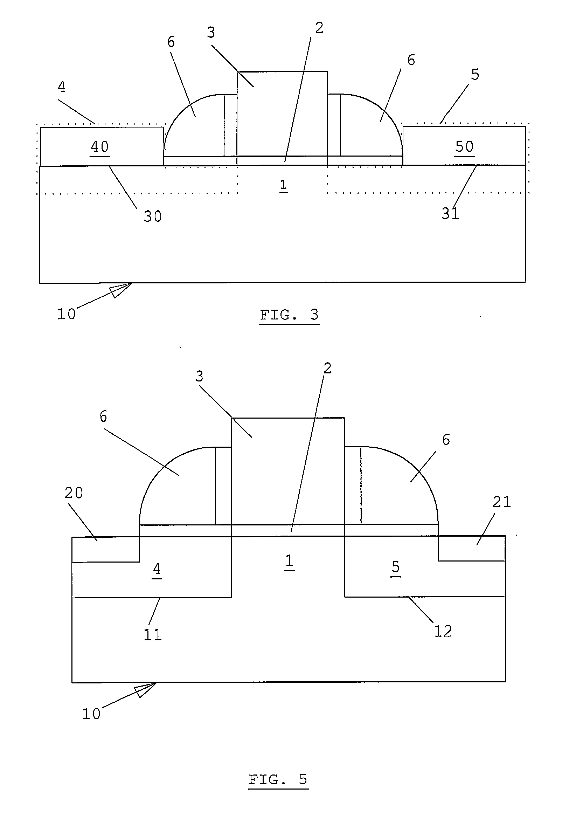

According to a third embodiment, shown in figure 3, the device comprises a III-V substrate 10, e.g. a GaAs substrate, and elevated source/drain portions 40 and 50 of SiGe are defined on top of said substrate, e.g. by selective deposition of SiGe in these regions. The dotted lines now define the actual source and drain areas 4 and 5, which now include a portion of SiGe and a portion of III-V material. As in the above cases, a heterojunction is formed between SiGe and III-V material, arranged so that the current passes through said heterojunction (30 and 31).

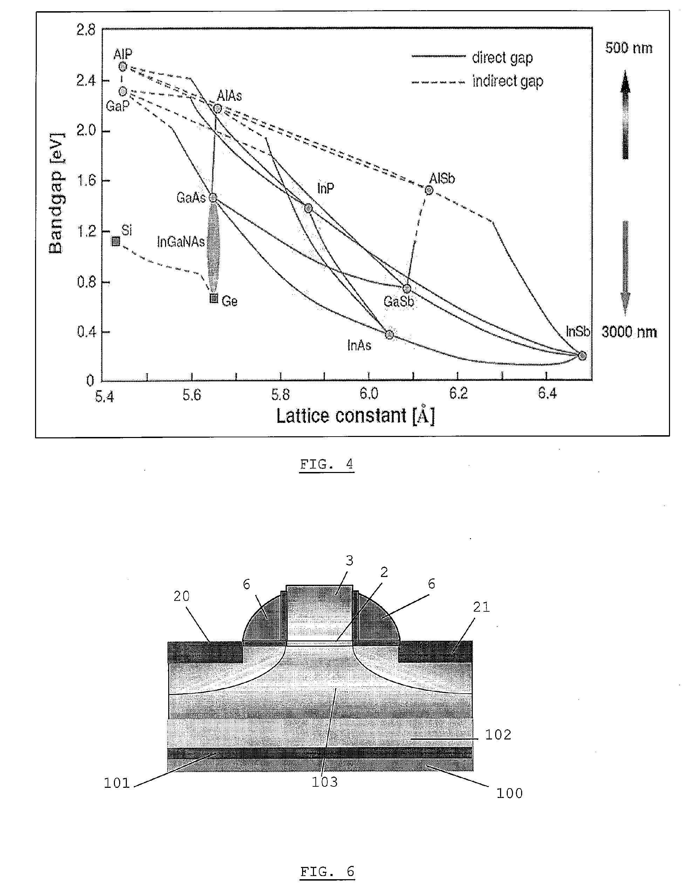

The III-V material used for the channel area 1 is preferably chosen from the list consisting of : GaAs, AlP, GaP, AlAs, InGaNAs, InGaAs, InP and AlSb. These materials have a bandgap above 1eV (fig. 4). The III-V material can also be a mixture of these elements. The channel material can equally be a III-V material with a low bandgap (i.e. <1eV), but that is not the preferred case.

The material of the source and drain 4 and 5 or of the elevated source and drain portions 40 and 50, is SiGe, which is actually SiₓGe₁₋ₓ, with x between 0 and 100%, as explained above.

The heterojunctions formed by the SiGe and III/V material will in the case of Germanium and GaAs most likely have a band alignment along the conduction band edge of these materials, making these junctions ideally suited for nMOS applications. Other III/V materials may have similar properties or may alternatively be used for pMOS when band alignment occurs at the valence band edge of these materials.

In the preferred embodiment, the III-V material and the source/drain material have substantially the same lattice constant. Ideal combinations are therefore : GaAs/Ge or AlAs/Ge, as can be derived from the graph in figure 4. The substrates 10 and 13 can be a bulk crystalline GaAs or SiGe substrates, or they can in turn be layers of GaAs or SiGe, applied by a deposition or layer transfer technique on another substrate, for example a silicon wafer. Such substrates are known: germanium-on-insulator (GOI), whereby a crystalline germanium layer upon a dielectric layer is present for growing layers of III/V material or silicon-on-insulator whereby a crystalline silicon layer upon a dielectric is present for growing silicon/germanium and germanium layers upon which layers of III/V material can be formed.

Germanidation and/or silicidation can be used (for example by forming Nickel Germanide - NiGe) on the SiGe regions, to form a region in said source and drain areas, said region consisting of a metal germanide and/or silicide, said region facilitating the contacting of the source and drain. According to an embodiment, after producing source and drain areas in SiGe, as in embodiments 1 and 2, preferably in pure Ge, a layer of a metal, e.g. Ni, is applied on the substrate, so that a region (20, 21) of NiGe is formed near the surface of the substrate, see figure 5. The formation of NiGe preferably occurs by applying a continuous layer of Ni on the totality of the substrate, and allowing NiGe to form on the Ge-regions. After that, the unreacted Ni on the remaining areas is removed by an etching step. This type of self-aligned production of NiGe-areas is known in the art. Other types of metal may be used, in combination with a source/drain area with various concentrations of Si and Ge in the SiₓGe₁₋ₓ areas, to form a metallic region by an alloy of a metal such as Pt, Pt, Co, Ni with the semiconductor material, SiₓGe₁. When x is between 0 and 100 excluding the boundary values, a mixed germanide/silicide compound will be formed with the applied metal.

Fig. 6 shows a specific embodiment of a MOSFET according to the first embodiment, comprising on a Si-wafer 100 :
- a graded Si/Ge layer 101, having a low concentration of Ge near the interface with Si, and a growing Ge-concentration while progressing to the opposite side, up to virtually 100% Ge at the top,
- a Ge layer 102, grown by selective epitaxy,
- A III-V layer 103, e.g. GaAs or GaₓIn₁₋ₓAs, grown by selective MOCVD on Ge
The layer 103 is then equivalent to the substrate 10 of figure 1. On this layer 103, the Ge-source and drain 4 and 5 are formed, e.g. by etching of the GaAs and epitaxial growth of Ge on GaAs. The device of figure 6 may also be built on a GeOI substrate (Germanium on Insulator) whereby layer 102 is then formed upon a dielectric layer.

The method of producing a device according to the first embodiment of the invention, comprises the steps of :
- providing a substrate having a top layer consisting of III-V material. This can be a III-V wafer 10, or a Si wafer 100 with a III-V layer 103 deposited on it, possibly with other layers (101,102) between the Si and the III-V, as shown for example in fig. 6,
- By photolithographic techniques, etching back two cavities 11 and 12 in the III-V layer, to form a channel area 1 in between said cavities,
- Filling up said cavities with SiGe, preferably by a selective deposition technique, e.g. by epitaxial growth, to form source and drain areas 4 and 5 in contact with the channel area 1. Other techniques can be applied to selectively form SiGe in said cavities, e.g. by uniform growth and subsequent removal of the SiGe outside the cavities using photolithographic patterning and etching steps known in the art.

The method of producing a device according to the second embodiment of the invention, comprises the steps of :
- providing a substrate having a top layer consisting of SiGe. This can be a SiGe wafer 13, or a Si wafer with a SiGe layer deposited on it, possibly with other layers between the Si and the SiGe,
- By photolithographic techniques, etching back a cavity 14 in the III-V layer, for forming a channel area 1,
- Filling up said cavity with III-V material, preferably by a selective deposition technique, e.g. by epitaxial growth, to form the channel area 1

The method of producing a MOSFET device according to the third embodiment of the invention, comprises the steps of :
- providing a substrate having a top layer consisting of III-V material. This can be a III-V wafer 10, or a Si wafer with a III-V layer 103 deposited on it, possibly with other layers (101,102) between the Si and the III-V, as shown for example in fig. 6,
- Depositing, preferably by a selective deposition technique, e.g. by epitaxial growth of SiGe, the source and drain regions 4 and 5 in contact with the channel area.

The method steps according to both embodiments, can then be followed by steps of doping the SiGe source and drain regions, and producing source, drain and gate contacts, by methods known in the art.

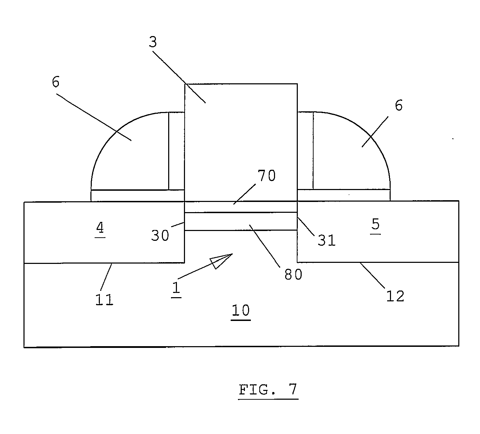

The invention is not limited to MOSFET devices. Also in other types of transistors, source and drain areas can be produced in SiGe, to form heterojunctions with e.g. GaAs. This can be the case for example in HEMT transistors (High Electron Mobility Transistor). As mentioned above, in a HEMT transistor, the structure of the III-V layer will be different from the case of a MOSFET, and will comprise multiple layers of III-V material. An example of such a HEMT structure is shown in figure 7. Active layers 70 and 80 are present underneath the gate electrode 3. At least the channel layer 80 is a III-V layer, e.g. a GaN layer. Layer 70 can also be III-V, e.g. AlGaN, as is known in the art. The channel can be formed at the interface between layers 70 and 80. If a third layer is present adjacent layer 80 opposite layer 70 then a two dimensional carrier gas is created in the channel layer 80 thereby forming a conductive path between source 4 and drain 5.

## Claims

1. A semiconductor transistor device comprising a channel area (1), said channel area comprising:
- a channel layer in which charge carriers can move when the transistor is turned on, in order to pass a current through the transistor,
- a source area (4) and a drain area (5), contacting the channel layer for providing current to and from said channel layer
wherein said channel layer consists of a III-V material, and said source and drain areas comprise SiₓGe₁₋ₓ, with x between 0 and 100%, arranged so that heterojunctions (30,31) are present between III-V material and SiₓGe₁₋ₓ, said heterojunctions being arranged so that said current passes through said heterojunctions (30,31).

2. The device according to claim 1, wherein said areas (1,4,5) are provided in a substrate (10,13) and
wherein said substrate comprises a top layer (10) of said III-V material, and wherein two openings (11,12) are present in said top layer, and wherein said openings have been filled with SiGe, to form said source and drain areas (4,5).

3. The device according to claim 1, wherein said areas (1,4,5) are provided in a substrate (10,13) and wherein said substrate comprises a top layer (13) of SiₓGe₁₋ₓ, and wherein an opening (14) is present in said top layer, and wherein said opening has been filled with III-V material, to form said channel area (1).

4. The device according to claim 1, wherein said areas (1,4,5) are provided in a substrate (10,13) and wherein said substrate comprises a top layer (10) of III-V material, and wherein elevated source and drain portions (40,50) are present on top of said top layer, said elevated source and drain portions comprising SiₓGe₁₋ₓ.

5. The device according to any one of claims 1 to 4, wherein said III-V material is chosen from the group consisting of GaAs, AlP, GaP, AlAs, InGaNAs, InGaAs, InP and AlSb.

6. The device according to any one of the previous claims, wherein said source and/or drain area are provided with a contact portion (20,21) consisting of a metal germanide and/or silicide.

7. The device according to any one of the preceding claims, wherein said device is a MOSFET.

8. The device according to any one of the preceding claims, wherein said device is a HEMT.

9. A method for producing a device according to claim 2, said method comprising the steps of :
- providing a substrate having a top layer (10) consisting of a III-V material,
- By a photolithographic technique, etching back two cavities (11,12) in the III-V layer, to form a channel area (1) in between said cavities,
- Filling up said cavities with SiGe, to form source and drain areas (4,5) in contact with the channel area

10. A method for producing a device according to claim 3, said method comprising the steps of :
- providing a substrate (13) having a top layer consisting of SiGe,
- By a photolithographic technique, etching back a cavity (14) in the III-V layer, for forming a channel area (1),
- Filling up said cavity (14) with III-V material, to form the channel area (1).

11. A method for producing a device according to claim 2, said method comprising the steps of :
- providing a substrate having a top layer (10) consisting of a III-V material, for forming a channel area (1)
- Depositing e.g. by epitaxial growth of SiGe, the source and drain regions (4,5) in contact with the channel area (1)

12. A device according to claim 1, wherein x is smaller than 100%.

13. A device according to claim 1, wherein x is smaller than 90%.

14. A device according to claim 1, wherein x is smaller than 80%.

15. A device according to claim 1, wherein x is smaller than 70%.
